# EUROPÄISCHE PATENTSCHRIFT

(11) **EP 2 176 442 B1**
(45) Veröffentlichungstag und Bekanntmachung des Hinweises auf die Patenterteilung: **21.05.2014**
(21) Anmeldenummer: 08716047.9
(22) Anmeldetag: 26.02.2008
(51) Int. Cl.: C23C 14/56

(54) **VAKUUMBEHANDLUNG VON BANDFÖRMIGEN SUBSTRATEN**
VACUUM TREATMENT OF STRIP-SHAPED SUBSTRATES
TRAITEMENT SOUS VIDE DE SUBSTRATS SOUS FORME DE BANDE

(30) Priorität: 26.02.2007 DE 102007009615
(43) Veröffentlichungstag der Anmeldung: 21.04.2010
(73) Patentinhaber: Leybold Optics GmbH, 63755 Alzenau (DE)
(72) Erfinder: FUKAREK, Wolfgang Dr., 01906 Burkau (DE); BONTSCHEW, Bontscho, 01307 Dresden (DE)
(74) Vertreter: Pohlmann, Bernd Michael
(86) Internationale Anmeldenummer: PCT/EP2008/001507
(87) Internationale Veröffentlichungsnummer: WO 2008/104362

(56) Entgegenhaltungen:
- WO-A-2005/116289
- DE-C1- 10 157 186
- DE-C1- 19 735 603
- US-A1- 2004 063 320

## Beschreibung

Die Erfindung bezieht sich auf eine Behandlungsanlage zur Vakuumbehandlung, insbesondere Vakuumbeschichtung einer Vorderseite von bandförmigen Substraten mit einer Prozesskammer und einer Prozesswalze und zumindest einer Prozessquelle und einer zweiten Prozesskammer mit einer Prozesswalze und zumindest einer Prozessquelle.

Bei den bandförmigen Substraten kann es sich um Metallbänder, Magnetbänder, Filme, Kunststofffolien oder dergleichen handeln, die der Prozessquelle, beispielsweise zur Beschichtung ausgesetzt werden. Als Prozessquelle werden üblicherweise Sputterquellen, insbesondere Magnetron-Sputterquellen, Aufdampf-, Plasma-Physical-Vapor-Deposition- oder Chemical-Vapor-Deposition-Quellen (PVD- oder CVD-Quellen) eingesetzt. Femer können diese Quellen auch für eine Vorbehandlung, Reinigung, Trocknung, Oberflächenaktivierung und/oder Polymerisierung des zu beschichtenden Substrats dienen. Durch den Einsatz von zwei Prozesskammern mit Prozessquellen kann der Durchsatz einer derartigen Anlage gegenüber einer Anlage mit nur einer Prozesskammer erhöht werden.

Außer DE 101 571 86 C1 ist eine Vakuumbeschichtungsanlagen zum Beschichten von bandförmigem Material in Prozesskammern bekannt, bei der in einer ersten evakuierbaren Haspelkammer eine Abwickeleinrichtung mit einem eingesetzten Abwickel des zu beschichtenden bandförmigen Materials angeordnet ist und in einer zweiten evakuierbaren Haspelkammer eine Aufwickeleinrichtung mit einem herausnehmbaren Aufwickel des zu beschichtendem Materials angeordnet ist. Das zu beschichtende bandförmige Material durchläuft zwei Prozesskammern mit Führungseinrichtungen mit einer Anzahl von Umlenkrollen für das bandförmige Substrat.

Aus der JP 00063206470 AA ist bereits eine Bandbeschichtungsanlage mit zwei Bearbeitungskammern und zwei Prozesswalzen bekannt, bei denen die beiden Prozesswalzen so angeordnet sind, dass nacheinander beide Seiten des Bandes beschichtet werden können.

Aus der JP00063020464AA ist ferner eine Anlage zur Bedampfung einer Seite eines Stahlbandes bekannt mit Auf- und Abwickelrollen, die außerhalb der Bearbeitungskammer angeordnet sind. Die Aufwickel- und Abwickeleinrichtungen sind über Schleusen mit der Bearbeitungskammer verbunden.

Femer ist das aus der DE 10 2005 042762 A1 eine Bandbeschichtungsanlage bekannt, bei der das Innere der Vakuumkammer durch eine Trennwand in eine Walzenkammer und eine Beschichtungskammer getrennt ist. Aufwickel- und Abwickelwalzen befinden sich ebenfalls in der Vakuumkammer.

Eine weitere Bandbehandlungsanlage ist aus der WO 2005/116289 bekannt, bei der ein Wechsel von Abwickel- und Aufwickelspulen möglich ist, ohne die gesamt Anlage beziehungsweise deren evakuierten Behandlungstrakt zu lüften. Dazu werden Wickelstation und Behandlungsstation in oder auf unterschiedlichen relativ zueinander bewegbaren Basen angeordnet. Die Basis der Behandlungsstation ist ein fester Teil des Anlagengehäuses, das im Betriebszustand auch die Wickelstation umgibt. Letztere sind in einem ihre gemeinsame Basis umfassenden und zum Behandlungsmodul hin offenen gegenüber dem Anlagengehäuse beweglichen Gestell angeordnet und durch Ventile gegenüber der eigentlichen Behandlungsstation abdichtbar. Von außen sind die Winkelstationen über gesonderte, im Betrieb dicht verschließbare Öffnungen des Anlagengehäuses zugänglich.

DE 197 35 603 C1 offenbart eine Vakuumbeschichtungsanlage, bei der im Vakuum eine Abwickeleinrichtung in einer ersten Haspelkammer (2) und eine Aufwickeleinrichtung in einer zweiten Haspelkammer (3) angeordnet sind, zwischen denen das zu beschichtende Material durch eine erste Beschichtungskammer geführt wird, in der Umlenkrollen, Bandzugmesswalzen und ein Beschichtungsstation angeordnet sind, wobei die Beschichtungsstation aus mindestens einer Kühlwalze und mindestens einem über der Oberfläche der Kühlwalze angeordneten Magnetron besteht, wobei in Bandlaufrichtung hinter der ersten Beschichtungskammer (1) eine zweite Beschichtungskammer (1') angeordnet ist, und in beiden Beschichtungskammern (1; 1') je ein Walzenstuhl angeordnet ist, in dem die Umlenkrollen, Bandzugmesswalzen und Kühlwalzen (7) gelagert sind.

Bei den bekannten Verfahren wird das bandförmige Substrat zwischen einer Behandlungsstation und den Wickelstationen mittels Umkehrrollen geführt, die die Vorderseite des Substrates berühren.

Zur Herstellung von Dünnschicht-Solarzellen, beispielsweise auf der Basis von Kupfer-Indiom-Selenit (CIS) mit einer transparenten Zinkoxyd-Fensterschicht erfolgt eine einseitige Beschichtung von bandförmigen Substraten mittels PVD- oder CVD- Prozessen. Bei der einseitigen Beschichtung darf das bandförmige Substrat lediglich auf der Rückseite berührt werden, wenn die Beschichtung auf der Vorderseite erfolgt ist. Auch bei anderen Prozessen kann es erforderlich sein, eine Berührung einer Substrat- Vorderseite zu minimieren oder gänzlich zu vermeiden. Dieses Erfordernis motiviert eine Behandlungsanlage ohne die üblichen Band - Umlenkrollen, die das Substrat auf der Vorderseite berühren.

Aufgabe der vorliegende Erfindung ist es, eine gattungsgemäße Behandlungsanlage sowie ein gattungsgemäßes Verfahren zur Vakuumbehandlung, insbesondere Vakuumbeschichtung bandförmigen Substraten zur Verfügung zu stellen, bei der zur Substratführung keine Berührung der Vorderseite des Substrats erforderlich ist.

Die Aufgabe wird erfindungsgemäß durch die Merkmale der unabhängigen Patentansprüche gelöst.

Erfindungsgemäß ist bei einer Behandlungsanlage zur Vakuumbehandlung, insbesondere Vakuumbeschichtung zumindest eines Bereichs einer Vorderseite von bandförmigen Substraten in einer ersten Prozesskammer mit einer ersten Prozesswalze und zumindest einer Prozessquelle und einer zweiten Prozesskammer mit einer zweiten Prozesswalze und zumindest einer Prozessquelle vorgesehen, dass
eine zwischen der ersten und der zweiten Prozesskammer angeordnete Transferkammer, welche mit beiden Prozesskammern gekoppelt und druckmäßig von zumindest einer der Prozesskammern trennbar ist und eine Abwickeleinrichtung mit einem herausnehmbaren Abwickel und eine Aufwickeleinrichtung mit einem heraus nehmbaren Aufwickel für das zu behandelnde Substrat sowie eine Außenschleuse zur Be- und Entladung von Abwickel und/oder Abwickel aufweist,
wobei das zu behandelnde Substrat mit seiner Rückseite der ersten und zweiten Prozesswalze zugewandt ist und von der Abwickeleinrichtung zur ersten Prozesswalze, von der ersten Prozesswalze zur zweiten Prozesswalze und von der zweiten Prozesswalze zur Aufwickeleinrichtung durch die Transferkammer führbar ist.

Der zu beschichtende Bereich der Vorderseite ist vorzugsweise ein Streifen parallel zu den Rändern des bandförmigen Substrats, der sich auch über die gesamte Breite des Substrats erstrecken kann.

Die Anordnung der Transferkammer zwischen der ersten und der zweiten Prozesskammer und die Führung des zu beschichtenden Substrats von der Abwickeleinrichtung zur ersten Prozesswalze, von der ersten Prozesswalze zur zweiten Prozesswalze und von der zweiten Prozesswalze zur Aufwickeleinrichtung durch die Transferkammer, ermöglicht es auf Umlenkrollen, welche einen vorgegebenen Bereich, vorzugsweise den zu beschichtenden Bereich der Vorderseite des bandförmigen Substrats berühren, zu verzichten. Es versteht sich, dass auch eine Berührung des betreffenden Bereichs des bandförmigen Substrats durch andere Anlagenkomponenten vermieden werden kann.

Bevorzugt ist es, wenn die Führungseinrichtungen, insbesondere Rollen und Umlenkrollen für das zu behandelnde Substrat zwischen Abwickeleinrichtung und erster Prozesswalze, zwischen erster Prozesswalze und zweiter Prozesswalze und/oder zweiter Prozesswalze und Aufwickeleinrichtung nur die Rückseite des Substrates berühren oder entsprechend die Vorderseite des Substrats zumindest in dem vorgegebenen Bereich berührungsfrei geführt wird.

Es versteht sich aber auch, dass von der Erfindung Ausführungsformen umfasst werden, bei denen, beispielsweise unter genau definierten Bedingungen, eine Berührung der Vorderseite des bandförmigen Substrats durch Komponenten der Anlage erfolgt.

Mit besonderem Vorzug ist vorgesehen, dass die erste und zweite Prozesskammer mit der Transferkammer derartig gekoppelt sind, dass Abwickel und/oder Aufwickel in die Transferkammer einladbar oder aus der Transferkammer ausladbar sind und dabei das Vakuum in zumindest einer der Prozesskammern aufrechterhalten bleibt. Das Beladen oder Entladen der Transferkammer kann daher ohne Belüftung der Gesamtanlage erfolgen. Günstig ist es, wenn die Transferkammer eine die erste und zweite Prozesskammer verbindende Zwischenkammer aufweist, sowie eine von der Zwischenkammer durch eine Wand getrennte Schleusenkammer, wobei die Zwischenkammer einen Kanal für das zu beschichtende Substrat bildet, in welchem das zu beschichtende Substrat von der ersten Prozesskammer zur zweiten Prozesskammer läuft. Die Schleusenkammer ist mit einer ersten Bandschleuse mit der ersten Prozesskammer und mit einer zweiten Bandschleuse mit der zweiten Prozesskammer gekoppelt. Die Bandventile können als Quetschventile ausgebildet sein, die im Betrieb der Anlage einen ausreichend großen Querschnitt haben, um einen berührungsfreien Durchlauf des Substrats zu gewährleisten. Ein geeignetes Bandventil ist beispielsweise aus der WO 99/50472 bekannt. Femer kann die Zwischenkammer mit einer ersten und/oder einer zweiten Bandschleuse mit der ersten und/oder zweiten Prozesskammer gekoppelt sein, wodurch über gegebenenfalls vorhandene Zugangsöffnungen gegebenenfalls vorgesehene Führungseinrichtungen des Substrats in der Zwischenkammer oder andere Komponenten für Wartungs- oder Justierarbeiten zugänglich sind, ohne dass das Vakuum in den Prozesskammern gebrochen werden muss.

Wenn die erste und/oder zweite Prozesswalze kühlbar und/oder heizbar ist, also als Kühl- und/oder Heizwalze ausgebildet ist, kann das bandförmige Substrat während der Beschichtung in einem vorgegebenen Temperaturbereich gehalten werden und damit die Prozessqualität- und -Sicherheit gewährleistet oder erhöht werden.

Um eine effiziente Bearbeitung des Substrats zu erreichen, ist es vorteilhaft, wenn in der oder den Prozesskammern eine Mehrzahl von Prozessquellen angeordnet ist. Die Mehrzahl der Prozessquellen bildet einen Prozessbereich auf der Vorderseite des durchlaufenden bandförmigen Substrats, der mit der Anzahl der Prozessquellen wächst. Für eine sichere Prozessführung ist es vorteilhaft, wenn der Prozessbereich der Prozessquellen in einem Bereich einer Umschlingung der Prozesswalze durch das Substrat liegt, da dann das Substrat während der Wirkung der Prozessquellen eine Unterstützung durch die Prozesswalze erfährt. Eine hohe Effektivität der Anlage wird erreicht, wenn das Substrat die Prozesswalze in einem Prozessbereich der Prozessquellen mit einer Umschlingung von zumindest 180° umschlingt. In einer weiteren Ausführungsform kann auch eine Umschlingung mit mehr als 180° vorgesehen sein. Der Grad der Umschlingung kann durch die relative Positionierung von Aufwickel- und Abwickeleinrichtung zur ersten beziehungsweise zweiten Prozesswalze bestimmt oder eingestellt werden.

Bevorzugt dient die Behandlungsanlage zur Vakuumbeschichtung von Substraten, wobei als Prozessquellen eine Sputterquellen, Magnetron-Sputterquellen, Aufdampf-, Plasma-PVD- oder CVD-Quellen eingesetzt werden. Es versteht sich, dass auch Quellen für Vorbehandlung, Reinigung, Trocknung, Oberflächenaktivierung und/oder Polymerisierung des zu behandelnden Substrats denkbar sind. Falls die Quelle eine Sputterquelle ist, kann diese ein planares oder ein zylindrisches Target aufweisen. Ferner können die erste Prozesskammer mit einer Prozessquelle mit einem planaren Target und die zweite Prozessquelle mit einem zylindrischen Target ausgestattet sein. Ebenso ist eine umgekehrte Konfiguration vorstellbar. Derartige Konfigurationen können besonders günstig für die Herstellung von CIGS-Solarzellen eingesetzt werden. Ein planares Target wird bevorzugt zur Beschichtung mit undotiertem Zink (i-ZnO) eingesetzt, während zylindrische Targets für die Herstellung von dotierten ZnO-Schichten bevorzugt werden. Es versteht sich, dass auch andere Konfigurationen von planaren und zylindrische Targets für andere Behandlungsprozesse denkbar sind.

Gemäß einem weiteren Aspekt der Erfindung wird bei einem Verfahren zur Vakuumbehandlung einer Vorderseite von bandförmigen Substraten in einer Prozesskammer mit einer Prozesswalze und zumindest einer Prozessquelle und einer zweiten Prozesskammer mit einer Prozesswalze und zumindest einer Prozessquelle das zu behandelnde Substrat von einer Abwickeleinrichtung zur ersten Prozesswalze, von der ersten Prozesswalze zur zweiten Prozesswalze und von der zweiten Prozesswalze zu einer Aufwickeleinrichtung geführt wird und dabei mit seiner Rückseite der ersten und der zweiten Prozesswalze zugewandt ist. Die Abwickeleinrichtung und die Aufwickeleinrichtung sind in einer zwischen der ersten und zweiten Prozesskammer angeordneten und mit beiden gekoppelten, druckmäßig von zumindest einer der Prozesskammern trennbaren Transferkammer angeordnet. Das erfindungsgemäße Verfahren hat den Vorteil, dass das die Führung des zu behandelnden bandförmigen Substrats zwischen Aufwickeleinrichtung und Abwickeleinrichtung keine Berührung der zu behandelnden Vorderseite des bandförmigen Substrats durch Umlenkrollen erfordert.

Nachfolgend werden bevorzugte Ausführungsformen der Erfindung anhand einer Zeichnung genauer beschrieben, aus denen sich auch unabhängig von ihrer Zusammenfassung in den Patentansprüchen weiter Aspekte und Vorteile der Erfindung ergeben.

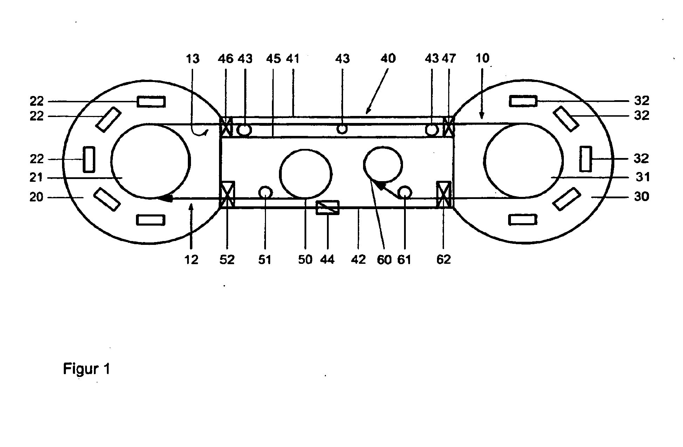

Die Figur 1 zeigt eine stark vereinfachte Darstellung einer erfindungsgemäßen Behandlungsanlage zur Vakuumbehandlung eines bandförmigen Substrats 10 in einem Vertikalschnitt zu den Drehachsen von zwei Prozesswalzen.

Die Behandlungsanlage umfasst eine erste Prozesskammer 20 mit einer Prozesswalze 21, eine zweite Prozesskammer 30 mit einer Prozesswalze 31 und eine zwischen der ersten und zweiten Prozesskammer angeordneten Transferkammer 40. Femer sind nicht dargestellte Steuereinrichtungen zur Prozesskontrolle der Behandlung vorgesehen.

Die Prozesswalzen 21 und 31 sind in nicht dargestellten Walzenstühlen angeordnet, die beispielsweise eine Justierung ermöglichen ihrer Achsenlagen erlauben und weisen im wesentlichen parallel zu einander angeordnete Drehachsen auf. Die Transferkammer 40 ist mit den Prozesskammern 20 und 30 gekoppelt. Die Prozesskammern 20, 30 und die Transferkammer 40 sind durch nicht dargestellte Vakuumpumpen evakuierbar. In der Transferkammer 40 ist eine Abwickeleinrichtung 50 für einen Abwickel, der einen Vorrat von Bandmaterial zur Verfügung stellt und eine Aufwickeleinrichtung 60 mit einem Aufwickel angeordnet. Vorzugsweise sind die Achsen von Aufwickel und Abwickel parallel zu einander und zu den Achsen der Prozesswalzen angeordnet.

Als bandförmiges Substrat 10 sind Metallbänder, Magnetbänder, Filme, Kunststofffolien oder dergleichen vorgesehen, die den Prozessquellen 21, 31 mit einer Seite zur Behandlung, beispielsweise zur Beschichtung ausgesetzt werden.

In der Prozesskammer 20 ist zumindest eine Prozessquelle 22 vorzugsweise eine Anzahl von Prozessquellen 22 angeordnet. Ebenso ist in der Prozesskammer 30 zumindest eine, vorzugsweise eine Anzahl von Prozessquellen 32 angeordnet. Bevorzugt sind die Prozessquellen 22, 32 Magnetron-Sputterquellen. Es ist jedoch denkbar, dass auch andere Sputterquellen, Aufdampf-Plasma-PVD- oder CVD-Quellen eingesetzt werden. Femer kann es sich bei dem Prozessquellen auch Quellen für Vorbehandlung, Reinigung, Trocknung, Oberflächenaktivierung und/oder Polymerisierung des zu behandelnden Substrats handeln. Vorzugsweise erstreckt sich eine Quelle jeweils über eine vorgegebene Länge parallel zur Drehachse der jeweiligen Prozesswalze. Die Prozessquellen 22 und/oder 32 sind ferner, wie in Figur 1 dargestellt, kreisringartig um die jeweilige Prozesswalze 21 oder 31 angeordnet, um eine möglichst große Behandlungszone für das Substrat 10 zu bilden.

Als Vorderseite 12 des bandförmigen Substrats 10 wird für die Zwecke der Erfindung die Seite des Substrats 10 definiert, die in der Prozesskammer 20 und der Prozesskammer 30 durch die Prozessquellen 22 und/oder 32 eine Behandlung, vorzugsweise einer Beschichtung unterworfen wird. Die Vorderseite 12 ist vorzugsweise, aber nicht notwendigerweise bei einem Aufwickel und/oder Abwickel radial nach außen gerichtet. Als Rückseite 13 wird die entgegengesetzte Seite des Substrats 10 bezeichnet.

Die Transferkammer 40 umfasst eine Zwischenkammer 41 und eine Schleusenkammer 42, die durch eine Wand 45 getrennt sind. die Zwischenkammer 41 bildet einen Kanal für das zu behandelnde Substrat, in welchem dieses von der ersten Prozesskammer 20 zur zweiten Prozesskammer 30 läuft. Die Zwischenkammer 41 kann durch Bandventile 46 und 47 von der Prozesskammer 20 beziehungsweise 30 druckmäßig getrennt werden. Die Bandventile 46 und 47 sind optional, sodass gemäß einem weiteren Aspekt der Erfindung entweder beide oder eines dieser Ventile fehlen.

Die Schleusenkammer 42 ist mit einer Bandschleuse 52 mit der ersten Prozesskammer 20 und einer Bandschleuse 62 mit der zweiten Prozesskammer 30 gekoppelt.

Ersichtlich sind die erste Prozesskammer 20 und die zweite Prozesskammer 30 mit der Transferkammer 40 derart gekoppelt, dass Abwickel oder Aufwickel in die Transferkammer 40 ein- beziehungsweise ausladbar sind, wobei das Vakuum oder ein eingestellter Druck in zumindest einer der Prozesskammern 20 oder 30 erhalten bleibt. Die die Zwischenkammer 41 von der Schleusenkammer 42 trennende Wand 45, grenzt an oder erstreckt sich in einen Bereich der Prozesskammer 20 sowie einen Bereich der Prozesskammer 30. Die Schleusenkammer 42 ist bei geschlossenen Bandventilen 52 und 62 druckmäßig vakuummäßig von der Prozesskammer 20 und der Prozesskammer 30 getrennt, sodass die Abwickel 50 und die Aufwickel 60 über die Außenschleuse 44 zugängig sind, ohne die Prozesskammer 20 oder die Prozesskammer 30 belüften zu müssen.

Gemäß einem weiteren Aspekt der Erfindung ist die Transferkammer 40 einteilig ausgebildet.

Die Prozesswalze 21 und/oder die Prozesswalze 31 können jeweils als Heiz- und/oder Kühlwalze ausgebildet sein, wie an sich bereits bekannt.

Die Bandventile 46, 47, 52, 62 weisen in geöffnetem Zustand eine ausreichend große lichte Weite auf, um einen berührungslosen Transport des bandförmigen Substrat zu erlauben. Im geschlossenen Zustand ermöglichen sie eine druckmäßige Entkopplung der jeweiligen Prozesskammer von der Transferkammer. Darüber hinaus kann im geschlossenen Zustand einer Bandschleuse das bandförmige Substrat 10 durch die jeweilige Bandschleuse festgehalten werden. Dies ist vorteilhaft, um Teillängen des bandförmigen Substrat 10 abzutrennen und gegebenenfalls einen weiteren Vorrat von Substrat an das festgehaltene Ende anzubringen, beispielsweise durch Heften oder Schweißen.

Die Abwickeleinrichtung 50 weist eine Führungseinrichtung 51 auf, der das bandförmige Substrat 10 mit seiner Rückseite 13 zugewandt ist, sodass keine Berührung der Vorderseite 12 erfolgt. Ferner weist die Aufwickeleinrichtung 60 eine Führungseinrichtung auf, die ebenfalls ohne Berührung der Vorderseite 12 arbeitet. Femer sind im Bereich der Zwischenkammer 41 Führungseinrichtungen 43 vorgesehen, die die Vorderseite 12 des bandförmigen Substrats nicht berühren, so dass das Substrat 10 frei von Berührung seiner Vorderseite 13 führbar ist.

Bei Betrieb der Anlage ist das bandförmige Substrat 10 mit seiner Rückseite 13 der Prozesswalze 21 und der Prozesswalze 22 zugewandt. Das zu behandelnde bandförmige Substrat wird von der Abwickeleinrichtung zur Prozesswalze 21 geführt, umschlingt diese und wird von ihr umgelenkt in Richtung der Prozesswalze 31 geführt. Zwischen der Prozesswalze 21 und der Prozesswalze 31 wird das bandförmige Substrat durch die Transferkammer 40 geführt. In der Darstellung der Figur 1 erfolgt ein Transfer des Substrats 10 durch die einen Tunnel mit relativ kleinem lichten Querschnitt bildende Zwischenkammer 41.

Das Substrat 10 umschlingt die Prozesswalze 31 und wird umgelenkt und über das Bandventil 62 zur Aufwickeleinrichtung 60. geführt. Während des Transports zwischen Abwickel - und Aufwickeleinrichtung 50 und 60 und der Behandlung des Substrats 10 in der erfindungsgemäßen Behandlungsanlage ist keine Berührung der Vorderseite 12 des Substrats erforderlich. Sämtliche Umlenke und Führungseinrichtungen greifen an der Rückseite 13 des bandförmigen Substrats an, sodass eine Beschädigung oder Kontaminierung der Vorderseite 12 minimiert oder vollständig verhindert werden kann.

Das bandförmige Substrat kann mit seiner Rückseite 13 auf einem Zwischenband angeordnet sein. Gegebenenfalls kann das Substrat 10 von einem Zwischenband vor der Behandlung in der Behandlungsanlage abgezogen und nach der Behandlung wieder auf ein Zwischenband aufgebracht werden. Es versteht sich, dass auch eine Behandlung des bandförmigen Substrats, welches aus zwei oder mehr aufeinander angeordneten Schichten besteht, in der erfindungsgemäßen Anlage oder mittels des erfindungsgemäßen Verfahrens denkbar ist.

### Bezugszeichenliste

- 10: Bandförmiges Substrat
- 12: Vorderseite des bandförmigen Substrats
- 13: Rückseite des bandförmigen Substrats
- 20: Prozesskammer 1
- 21: Prozesswalze 1
- 22: Prozessquellen
- 30: Prozesskammer 2
- 31: Prozesswalze 2
- 32: Prozessquellen
- 40: Transferkammer
- 41: Zwischenkammer
- 42: Schleusenkammer
- 43: Führungseinrichtung
- 50: Abwickeleinrichtung
- 51: Führungseinrichtung
- 52: Bandventil
- 60: Aufwickeleinrichtung
- 61: Führungseinrichtung
- 62: Bandventil

## Patentansprüche

1. Behandlungsanlage zur Vakuumbehandlung, insbesondere Vakuumbeschichtung zumindest eines Bereichs einer Vorderseite von bandförmigen Substraten in einer ersten Prozesskammer mit einer ersten Prozesswalze und zumindest einer Prozessquelle und einer zweiten Prozesskammer mit einer zweiten Prozesswalze und zumindest einer Prozessquelle, **gekennzeichnet durch**
eine zwischen der ersten und der zweiten Prozesskammer angeordnete Transferkammer, welche mit beiden Prozesskammern gekoppelt und druckmäßig von zumindest einer der Prozesskammern trennbar ist und eine Abwickeleinrichtung mit einem herausnehmbaren Abwickel und eine Aufwickeleinrichtung mit einem heraus nehmbaren Aufwickel für das zu behandelnde Substrat sowie eine Außenschleuse zur Be- und Entladung von Abwickel und/oder Aufwickel aufweist,
wobei das zu behandelnde Substrat mit seiner Rückseite der ersten und zweiten Prozesswalze zugewandt ist und von der Abwickeleinrichtung zur ersten Prozesswalze, von der ersten Prozesswalze zur zweiten Prozesswalze und von der zweiten Prozesswalze zur Aufwickeleinrichtung **durch** die Transferkammer führbar ist.

2. Behandlungsanlage nach Anspruch 1, **dadurch gekennzeichnet, dass** die erste und zweite Prozesskammer mit der Transferkammer derartig gekoppelt sind, dass Abwickel und/oder Aufwickel in die Transferkammer einladbar oder aus der Transferkammer ausladbar sind und dabei das Vakuum in zumindest einer der Prozesskammern aufrecht erhalten bleibt.

3. Behandlungsanlage nach Anspruch 2, **dadurch gekennzeichnet, dass** die Transferkammer eine die erste und zweite Prozesskammer verbindende Zwischenkammer und eine von der Zwischenkammer durch eine Wand getrennte Schleusenkammer umfasst, wobei die Zwischenkammer einen Kanal für das zu behandelnde Substrat bildet, in dem das zu behandelnde Substrat von der ersten Prozesskammer zur zweiten Prozesskammer läuft, die Schleusenkammer mit einer ersten Bandschleuse mit der ersten Prozesskammer und mit einer zweiten Bandschleuse mit der zweiten Prozesskammer gekoppelt ist aufweist.

4. Behandlungsanlage nach Anspruch 3, **dadurch gekennzeichnet, dass** die Zwischenkammer mit einer ersten Bandschleuse mit der ersten Prozesskammer und/oder mit einer zweiten Bandschleuse mit der zweiten Prozesskammer gekoppelt ist.

5. Behandlungsanlage nach einem der vorhergehenden Ansprüche, **dadurch gekennzeichnet, dass** die erste und/oder zweite Prozesswalze kühlbar und/oder heizbar ist.

6. Behandlungsanlage nach einem der vorhergehenden Ansprüche, **dadurch gekennzeichnet, dass** in der ersten Prozesskammer eine Mehrzahl von Prozessquellen angeordnet ist und/oder das zu behandelnde Substrat die Prozesswalze in einem Prozessbereich der Prozessquellen mit einer Umschlingung von zumindest 180° umschlingt.

7. Behandlungsanlage nach einem der vorhergehenden Ansprüche, **dadurch gekennzeichnet, dass** in der zweiten Prozesskammer eine Mehrzahl von Prozessquellen angeordnet ist und/oder das behandelnde Substrat die Prozesswalze in einem Prozessbereich der Prozessquellen mit einer Umschlingung von zumindest 180° umschlingt.

8. Behandlungsanlage nach einem der vorhergehenden Ansprüche, **dadurch gekennzeichnet, dass** in der Zwischenkammer zumindest eine Führungseinrichtung für das zu behandelnde Substrat angeordnet ist.

9. Behandlungsanlage nach einem der vorhergehenden Ansprüche, **dadurch gekennzeichnet, dass** die Abwickeleinrichtung zumindest eine Führungseinrichtung und/oder die Aufwickeleinrichtung zumindest eine Führungseinrichtung für das zu behandelnde Substrat umfasst.

10. Behandlungsanlage nach zumindest einem der vorhergehenden Ansprüche, **dadurch gekennzeichnet, dass** zumindest eine der Prozessquellen eine Sputterquelle, Mag Magnetronsputterquelle, Aufdampf-, Plasma-, PVD- oder CVD-Quelle oder eine Quelle für eine Vorbehandlung, Reinigung, Trocknung, Oberflächenaktivierung und/oder Polymerisierung des zu behandelnden Substrats vorgesehen ist.

11. Behandlungsanlage nach Anspruch 10, **dadurch gekennzeichnet, dass** die Sputter- oder Magnetronsputterquelle ein planeres Target aufweist.

12. Behandlungsanlage nach Anspruch 10 oder 11, **dadurch gekennzeichnet, dass** die Sputter- oder Magnetronsputterquelle ein zylindrisches Target aufweist.

13. Behandlungsanlage nach einem der Ansprüche 10 bis 12, **dadurch gekennzeichnet, dass** die erste und/oder zweite Prozesskammer mit zumindest einer Magnetronsputterquelle mit einem planaren Target und mit zumindest einer Magnetronsputterquelle mit einem zylindrischen Target ausgestattet sind.

14. Behandlungsanlage nach einem der vorhergehenden Ansprüche, **dadurch gekennzeichnet, dass** das zu behandelnde Substrat zumindest während eines vorgegebenen Betriebszustandes von der oder den Führungseinrichtungen nicht auf einem vorgegebenen Bereich seiner Vorderseite berührbar ist, berührt wird und/oder der oder den Führungseinrichtungen nur mit seiner Rückseite zugewandt ist.

15. Behandlungsanlage nach-einem der vorhergehenden Ansprüche, **dadurch gekennzeichnet, dass**, das die Führungseinrichtungen für das zu behandelnde Substrat zwischen Abwickeleinrichtung und erster Prozesswalze, zwischen erster Prozesswalze und zweiter Prozesswalze und/oder zweiter Prozesswalze und Aufwickeleinrichtung nur die Rückseite des Substrates berühren oder die Vorderseite zumindest in dem vorgegebenen Bereich nicht berühren.

16. Verfahren zur Vakuumbehandlung, insbesondere Vakuumbeschichtung einer Vorderseite von bandförmigen Substraten in einer ersten Prozesskammer mit einer ersten Prozesswalze und zumindest einer Prozessquelle und einer zweiten Prozesskammer mit einer zweiten Prozesswalze und zumindest einer Prozessquellen, **dadurch gekennzeichnet, dass** das zu behandelnde Substrat von einer Abwickeleinrichtung zur ersten Prozesswalze, von der ersten Prozesswalze zur zweiten Prozesswalze und von der zweiten Prozesswalze zu einer Aufwickeleinrichtung geführt wird und dabei mit seiner Rückseite der ersten und der zweiten Prozesswalze zugewandt ist, wobei die Abwickeleinrichtung und die Aufwickeleinrichtung in einer zwischen der ersten und zweiten Prozesskammer angeordneten und mit beiden gekoppelten, druckmäßig von zumindest einer der Prozesskammern trennbaren Transferkammer angeordnet sind.

17. Verfahren nach Anspruch 16, **dadurch gekennzeichnet, dass** das zu behandelnde Substrat in der ersten Prozesskammer, der zweiten Prozesskammer und/oder der Transferkammer über zumindest eine Führungseinrichtung geführt wird und das zu behandelnde Substrat zumindest während eines vorgegebenen Betriebszustandes von der oder den Führungseinrichtungen nicht auf seiner Vorderseite berührt wird und/oder der oder den Führungseinrichtungen nur mit seiner Rückseite zugewandt ist.

## Claims

1. Treatment installation for the vacuum treatment, in particular vacuum coating, of at least one region of a front side of substrates in strip form in a first process chamber with a first process roller and at least one process source and a second process chamber with a second process roller and at least one process source, **characterized by**
a transfer chamber which is arranged between the first and second process chambers, is coupled with both process chambers and can be separated in terms of pressure from at least one of the process chambers and an unwinding device with a removable unwinding reel and a winding-up device with a removable winding-up reel for the substrate to be treated as well as an outside air lock for loading and unloading the unwinding reel and/or winding-up reel,
wherein the substrate to be treated is facing with its rear side toward the first and second process rollers and can be guided through the transfer chamber from the unwinding device to the first process roller, from the first process roller to the second process roller and from the second process roller to the winding-up device.

2. Treatment installation according to Claim 1, **characterized in that** the first and second process chambers are coupled with the transfer chamber in such a way that the unwinding reel and/or winding-up reel can be loaded into the transfer chamber and can be unloaded from the transfer chamber and during this the vacuum is maintained in at least one of the process chambers.

3. Treatment installation according to Claim 2, **characterized in that** the transfer chamber comprises an intermediate chamber connecting the first and second process chambers and a lock chamber separated from the intermediate chamber by a wall, wherein the intermediate chamber forms a channel for the substrate to be treated in which the substrate to be treated runs from the first process chamber to the second process chamber and the lock chamber is coupled with the first process chamber by a first strip lock and with the second process chamber by a second strip lock.

4. Treatment installation according to Claim 3, **characterized in that** the intermediate chamber is coupled with the first process chamber by a first strip lock and/or with the second process chamber by a second strip lock.

5. Treatment installation according to one of the preceding claims, **characterized in that** the first and/or second process roller is/are coolable and/or heatable.

6. Treatment installation according to one of the preceding claims, **characterized in that** a plurality of process sources are arranged in the first process chamber and/or the substrate to be treated wraps around the process roller in a process region of the process sources with a wrap of at least 180°.

7. Treatment installation according to one of the preceding claims, **characterized in that** a plurality of process sources are arranged in the second process chamber and/or the substrate to be treated wraps around the process roller in a process region of the process sources with a wrap of at least 180°.

8. Treatment installation according to one of the preceding claims, **characterized in that** at least one guiding device for the substrate to be treated is arranged in the intermediate chamber.

9. Treatment installation according to one of the preceding claims, **characterized in that** the unwinding device comprises at least one guiding device and/or the winding-up device comprises at least one guiding device for the substrate to be treated.

10. Treatment installation according to at least one of the preceding claims, **characterized in that** at least one of the process sources is a sputter source, magnetron sputter source, vapor coating, plasma, PVD or CVD source or a source for a pretreatment, cleaning, drying, surface activation and/or polymerization of the substrate to be treated.

11. Treatment installation according to Claim 10, **characterized in that** the sputter or magnetron sputter source has a planar target.

12. Treatment installation according to Claim 10 or 11, **characterized in that** the sputter or magnetron sputter source has a cylindrical target.

13. Treatment installation according to one of Claims 10 to 12, **characterized in that** the first and/or second process chamber is/are equipped with at least one magnetron sputter source with a planar target and with at least one magnetron sputter source with a cylindrical target.

14. Treatment installation according to one of the preceding claims, **characterized in that**, at least during a predetermined operating state, the substrate to be treated cannot be contacted/is not contacted by the guiding device or devices on a predetermined region of its front side and/or is only facing with its rear side toward the guiding device or devices.

15. Treatment installation according to one of the preceding claims, **characterized in that** the guiding devices for the substrate to be treated between the unwinding device and the first process roller, between the first process roller and the second process roller and/or the second process roller and the winding-up device only contact the rear side of the substrate or do not contact the front side, at least in the predetermined region.

16. Method for the vacuum treatment, in particular vacuum coating, of a front side of substrates in strip form in a first process chamber with a first process roller and at least one process source and a second process chamber with a second process roller and at least one process source, **characterized in that** the substrate to be treated is guided from an unwinding device to the first process roller, from the first process roller to the second process roller and from the second process roller to a winding-up device, and during this is facing with its rear side toward the first and second process rollers, wherein the unwinding device and the winding-up device are arranged in a transfer chamber which is arranged between the first and second process chambers, is coupled with both and can be separated in terms of pressure from at least one of the process chambers.

17. Method according to Claim 16, **characterized in that** the substrate to be treated is guided in the first process chamber, the second process chamber and/or the transfer chamber by means of at least one guiding device and, at least during a predetermined operating state, the substrate to be treated is not contacted on its front side by the guiding device or devices and/or is only facing with its rear side toward the guiding device or devices.

## Revendications

1. Installation de traitement permettant le traitement sous vide, en particulier le revêtement sous vide d'au moins une partie du côté avant de substrats en forme de bande dans une première chambre de traitement qui présente un premier cylindre de traitement et au moins une source de traitement et dans une deuxième chambre de traitement qui présente un deuxième cylindre de traitement et au moins une source de traitement, l'installation étant **caractérisée par**
une chambre de transfert disposée entre la première et la deuxième chambre de traitement, raccordée aux deux chambres de traitement et apte à être séparée en termes de pression d'au moins l'une des chambres de traitement,
par un dispositif de déroulement qui présente un dérouleur apte à être retiré et un dispositif d'enroulement doté d'un enrouleur apte à être retiré pour le substrat à traiter ainsi qu'un sas extérieur qui permet de charger et de décharger le dérouleur et/ou l'enrouleur,
le substrat à traiter étant tourné par son côté arrière vers le premier et le deuxième cylindre de traitement et pouvant être amené par le dispositif de déroulement au premier cylindre de traitement, du premier cylindre de traitement au deuxième cylindre de traitement et du deuxième cylindre de traitement au dispositif d'enroulement dans la chambre de transfert.

2. Installation de traitement selon la revendication 1, **caractérisée en ce que** la première et la deuxième chambre de traitement sont raccordées à la chambre de transfert de telle sorte que le dérouleur et/ou l'enrouleur puissent être chargés dans la chambre de transfert ou déchargés dans la chambre de transfert tout en maintenant le vide dans au moins l'une des chambres de traitement.

3. Installation de traitement selon la revendication 2, **caractérisée en ce que** la chambre de transfert comporte une chambre intermédiaire qui relie la première et la deuxième chambre de traitement et une chambre de sas séparée de la chambre intermédiaire par une paroi, la chambre intermédiaire formant un canal pour le substrat à traiter, **en ce que** le substrat à traiter passe de la première chambre de traitement à la deuxième chambre de traitement et **en ce que** la chambre de sas est raccordée à un premier sas à bande par la première chambre de traitement et à un deuxième sas à bande par la deuxième chambre de traitement.

4. Installation de traitement selon la revendication 3, **caractérisée en ce que** la chambre intermédiaire est raccordée à la première chambre de traitement par un premier sas à bande et/ou est raccordée à la deuxième chambre de traitement par un deuxième sas à bande.

5. Installation de traitement selon l'une des revendications précédentes, **caractérisée en ce que** le premier et/ou le deuxième cylindre de traitement peuvent être refroidis et/ou chauffés.

6. Installation de traitement selon l'une des revendications précédentes, **caractérisée en ce que** plusieurs sources de traitement sont disposées dans la première chambre de traitement et/ou **en ce que** le substrat à traiter entoure par une spire d'au moins 180° le cylindre de traitement dans une zone de traitement des sources de traitement.

7. Installation de traitement selon l'une des revendications précédentes, **caractérisée en ce que** plusieurs sources de traitement sont disposées dans la deuxième chambre de traitement et/ou **en ce que** le substrat à traiter entoure par une spire d'au moins 180° le cylindre de traitement dans une zone de traitement de la source de traitement.

8. Installation de traitement selon l'une des revendications précédentes, **caractérisée en ce qu'**au moins un dispositif de guidage du substrat à traiter est disposé dans la chambre intermédiaire.

9. Installation de traitement selon l'une des revendications précédentes, **caractérisée en ce que** le dispositif de déroulement comporte au moins un dispositif de guidage du substrat à traiter et/ou **en ce que** le dispositif d'enroulement comporte au moins un dispositif de guidage du substrat à traiter.

10. Installation de traitement selon au moins l'une des revendications précédentes, **caractérisée en ce qu'**au moins l'une des sources de traitement est une source de pulvérisation, une source de pulvérisation à magnétron Mag, une source de vaporisation, une source de plasma, une source de PVD ou une source de CVD ou **en ce qu'**une source est prévue pour un prétraitement, un nettoyage, un séchage, une activation de surface et/ou une polymérisation du substrat à traiter.

11. Installation de traitement selon la revendication 10, **caractérisée en ce que** la source de pulvérisation ou de pulvérisation à magnétron présente une cible plane.

12. Installation de traitement selon les revendications 10 ou 11, **caractérisée en ce que** la source de pulvérisation ou la source de pulvérisation à magnétron présente une cible cylindrique.

13. Installation de traitement selon l'une des revendications 10 à 12, **caractérisée en ce que** la première et/ou la deuxième chambre de traitement sont équipées d'au moins une source de pulvérisation à magnétron dotée d'une cible plane et d'au moins une source de pulvérisation à magnétron dotée d'une cible cylindrique.

14. Installation de traitement selon l'une des revendications précédentes, **caractérisée en ce qu'**au moins pendant un état de fonctionnement prédéterminé, le substrat à traiter ne peut être touché ou n'est pas touché par le ou les dispositifs de guidage sur une partie prédéterminée de son côté avant et/ou **en ce qu'**il n'est tourné vers le ou les dispositifs de guidage que par son côté arrière.

15. Installation de traitement selon l'une des revendications précédentes, **caractérisée en ce que** les dispositifs de guidage du substrat à traiter ne touchent que le côté arrière du substrat entre le dispositif de déroulement et le premier cylindre de traitement, entre le premier cylindre de traitement, le deuxième cylindre de traitement et/ou le deuxième cylindre de traitement et le dispositif d'enroulement, ou ne touche pas le côté avant au moins dans la zone prédéterminée.

16. Procédé de traitement sous vide, en particulier de revêtement sous vide d'au moins une partie du côté avant de substrats en forme de bande dans une première chambre de traitement qui présente un premier cylindre de traitement et au moins une source de traitement et dans une deuxième chambre de traitement qui présente un deuxième cylindre de traitement et au moins une source de traitement,
**caractérisé en ce que**
le substrat à traiter est guidé par un dispositif de déroulement vers un premier cylindre de traitement, du premier cylindre de traitement vers le deuxième cylindre de traitement et du deuxième cylindre de traitement vers un dispositif d'enroulement, son côté arrière étant tourné vers le premier et le deuxième cylindre de traitement,
**en ce que** le dispositif de déroulement et le dispositif d'enroulement sont disposés dans une chambre de transfert située entre la première et la deuxième chambre de traitement, couplée aux deux chambres et apte à être séparée en termes de pression d'au moins l'une des chambres de traitement.

17. Procédé selon la revendication 16, **caractérisé en ce que** le substrat à traiter est guidé dans la première chambre de traitement, dans la deuxième chambre de traitement et/ou dans la chambre de transfert par au moins un dispositif de guidage et **en ce qu'**au moins pendant un état de fonctionnement prédéterminé, le substrat à traiter ne peut être touché ou n'est pas touché par le ou les dispositifs de guidage sur une partie prédéterminée de son côté avant et/ou **en ce qu'**il n'est tourné vers le ou les dispositifs de guidage que par son côté arrière.
